# EUROPEAN PATENT APPLICATION

(11) **EP 3 132 931 A1**
(43) Date of publication of application: **22.02.2017**
(21) Application number: 14889565.9
(22) Date of filing: 16.04.2014
(51) Int. Cl.: B32B 15/08, B05D 7/14, B05D 7/24, C09D 7/12, H01L 23/373, H01L 31/052, H01L 33/64, H02S 40/42

(54) **HEAT DISSIPATION FILM, DISPERSION LIQUID FOR HEAT EMISSION LAYER, METHOD FOR PRODUCING HEAT DISSIPATION FILM AND SOLAR CELL**

(71) Applicant: Sumitomo Seika Chemicals Co., Ltd., Kako-gun, Hyogo 675-0145 (JP); National Institute of Advanced Industrial Science and Technology, Tokyo 100-8921 (JP); Ceramission Co. Ltd., Tokyo 107-0062 (JP)
(72) Inventor: UMEDA Yuki, Kako-gun Hyogo 675-0145 (JP); BANDO Seiji, Kako-gun Hyogo 675-0145 (JP); KAWASAKI Kazunori, Kako-gun Hyogo 675-0145 (JP); KATO Toshihiko, Kako-gun Hyogo 675-0145 (JP); EBINA Takeo, Sendai-shi Miyagi 983-8551 (JP); HAYASHI Hiromichi, Sendai-shi Miyagi 983-8551 (JP); NAKAMURA Takashi, Sendai-shi Miyagi 983-8551 (JP); OHTA Akira, Tokyo 107-0062 (JP); NAITO Takashi, Tokyo 107-0062 (JP)
(74) Representative: Webster, Jeremy Mark
(86) International application number: PCT/JP2014/060828
(87) International publication number: WO 2015/159387

(57) **Abstract**

The present invention provides a heat dissipation film having high mechanical strength and flexibility, which is obtained by laminating a heat emission layer excellent in heat dissipation by infrared radiation, electrical insulation, and heat resistance on a metal film having excellent heat transfer efficiency. The present invention also provides a dispersion for heat emission layers for use in the production of the heat dissipation film, a method for producing a heat dissipation film using the dispersion for heat emission layers, and a solar cell including the heat dissipation film. The present invention provides a heat dissipation film including a heat transfer layer; and a flexible heat emission layer laminated on the heat transfer layer, the heat transfer layer being a metal film, the heat emission layer containing a water-insoluble inorganic compound and a heat-resistant synthetic resin, the amount of the water-insoluble inorganic compound in the heat emission layer being 30 to 90% by weight relative to the total weight of the heat emission layer, the heat emission layer having a thermal emissivity of at least 0.8 and a dielectric breakdown strength of at least 10 kV/mm.

## Description

### TECHNICAL FIELD

The present invention relates to a heat dissipation film to be used to dissipate heat generated from built-in components such as IC chips and LEDs in electronic devices. The present invention also relates to a dispersion for heat emission layers for use in the production of the heat dissipation film, a method for producing a heat dissipation film using the dispersion for heat emission layers, and a solar cell including the heat dissipation film.

### BACKGROUND ART

While recent electronic devices are becoming smaller, lighter, and thinner, there is an increasing demand for more various and higher functions of built-in IC chips in electronic devices, and circuits with higher integration densities have been developed. These IC chips generate heat due to leakage current during operation, dynamic power, conductor resistance, and the like. An increase in the amount of heat generated from IC chips due to the higher integration of circuits may destroy semiconductors and may cause problems such as malfunction and failure of electronic devices. In addition, while LEDs have been widely used lately for lighting, an increase in the amount of heat generation due to the higher integration causes problems such as a shorter life time of LEDs. Thus, the thermal design of these electronic components is very important. Various types of heat dissipation films have been developed as suitable heat dissipaters applicable to smaller and thinner electronic devices. These heat dissipation films are also required to have electrical insulation depending on use, in addition to high heat dissipation efficiency by heat transfer or radiation.

As an example of such heat dissipation films, Patent Literature 1 discloses a heat dissipation film including a graphite sheet having a high thermal conductivity as a heat transfer layer and a radioactive inorganic layer formed on the surface of the graphite sheet. The heat dissipation film disclosed in Patent Literature 1 is light and has a high thermal conductivity, and thus can transfer heat with high efficiency. However, the cost of the heat dissipation film is higher than that of metal films such as copper films or aluminium films that are used as heat transfer layers. In addition, graphite sheets have lower mechanical strength than metal films, and are thus highly susceptible to damage during handling of the film.

In addition, for example, Patent Literatures 2 to 4 disclose flexible heat dissipation films each including a metal film used as a heat transfer layer and a heat emission layer formed on the surface of the metal film. The heat dissipation films disclosed in Patent Literatures 2 and 3 contain a silicone resin as an inorganic binder in the heat emission layer. Unfortunately, such a heat emission layer containing a silicone resin has a low heat resistance, and also has poor adhesion with the metal film used as a heat transfer layer so that the heat emission layer easily comes off from the metal film. In the heat dissipation film disclosed in Patent Literature 4, graphite powder is used instead of an inorganic material as a filler for the heat emission layer, and the relationship between the average particle size and the film thickness is specified. Thus, the heat emission layer has excellent heat dissipation efficiency and good adhesion with a heat transfer layer; however, when the resin is filled with a large amount of graphite to improve the heat dissipation efficiency, the heat dissipation film cannot maintain electrical insulation.

### CITATION LIST

### - Patent Literature

Patent Literature 1: JP-A 2008-78380
Patent Literature 2: JP-A 2004-200199
Patent Literature 3: JP-A 2002-371192
Patent Literature 4: JP-A 2008-120065

### SUMMARY OF INVENTION

### - Technical Problem

The present invention aims to provide a heat dissipation film having high mechanical strength and flexibility, which is obtained by laminating a heat emission layer excellent in heat dissipation by infrared radiation, electrical insulation, and heat resistance on a metal film having excellent heat transfer efficiency. The present invention also aims to provide a dispersion for heat emission layers for use in the production of the heat dissipation film, a method for producing a heat dissipation film using the dispersion for heat emission layers, and a solar cell including the heat dissipation film.

### - Solution to Problem

The present invention provides a heat dissipation film including a heat transfer layer; and a flexible heat emission layer laminated on the heat transfer layer, the heat transfer layer being a metal film, the heat emission layer containing a water-insoluble inorganic compound and a heat-resistant synthetic resin, the amount of the water-insoluble inorganic compound in the heat emission layer being 30 to 90% by weight relative to the total weight of the heat emission layer, the heat emission layer having a thermal emissivity of at least 0.8 and a dielectric breakdown strength of at least 10 kV/mm.

The present invention is described in detail below.

The present inventors laminated a heat transfer layer made of a metal film and a heat emission layer containing a water-insoluble inorganic compound and a heat-resistant synthetic resin in specific proportions and having a thermal emissivity and a dielectric breakdown strength higher than specific values. As a result, they obtained a heat dissipation film high in mechanical strength and excellent in heat dissipation, electrical insulation, heat resistance, and flexibility. The present invention was completed based on such findings.

The heat dissipation film of the present invention includes a heat transfer layer.

The heat transfer layer functions to transfer heat generated from a heat source to a heat emission layer.

The heat transfer layer is a metal film.

The metal film is not particularly limited as long as it is made of a metal having a high thermal conductivity. Specifically, the thermal conductivity of a metal constituting the metal film is preferably at least 30 W/m·K, more preferably at least 200 W/m·K, for improving the heat dissipation properties.

Example of the metal film include copper films, aluminium films, gold films, silver films, tin films, nickel films, and alloy films containing metals constituting these films. Among these, copper films and aluminium films are preferred in terms of cost.

The lower limit of the thickness of the metal film is preferably 10 µm, and the upper limit thereof is preferably 1000 µm. When the thickness of the metal film is less than 10 µm, the heat transfer efficiency may be insufficient. When the thickness of the metal film is more than 1000 µm, the resulting heat dissipation film may be too heavy or may have poor flexibility. The lower limit of the thickness of the metal film is more preferably 100 µm. The upper limit thereof is more preferably 500 µm, still more preferably 300 µm.

The heat dissipation film of the present invention includes a heat emission layer.

The heat emission layer functions to radiate the heat transferred from the heat transfer layer in the form of infrared rays.

The heat emission layer contains a water-insoluble inorganic compound.

As used herein, the term "water-insoluble" means that the solubility in 100 mL of water at 20°C is less than 1.0 g.

Preferably, the water-insoluble inorganic compound includes, for example, at least one selected from the group consisting of a silica compound, a silica alumina compound, an aluminium compound, a calcium compound, a nitride, and coal ash. A silica compound, a silica alumina compound, and coal ash are more preferred among these. A phyllosilicate mineral and coal ash are still more preferred in view of thermal emission properties such as thermal emissivity.

As used herein, the "phyllosilicate mineral" is a silica compound. In addition, the term "coal ash" refers to ash such as fly ash and clinker ash which is produced when coal is burned at a thermal power plant, and it is a mixture of water-insoluble inorganic compounds in which the main component such as a silica compound or an aluminium compound accounts for 80 to 95% of the total components.

Examples of the phyllosilicate mineral include natural or synthetic mica, talc, kaolin, pyrophyllite, sericite, vermiculite, smectite, bentonite, stevensite, montmorillonite, beidellite, saponite, hectorite, and nontronite. Preferred among these for producing uniform heat dissipation films at low cost are non-swelling clay minerals such as talc, kaolin, pyrophyllite, non-swelling mica, and sericite, and more preferred is at least one selected from the group consisting of talc, kaolin, pyrophyllite, and non-swelling mica.

Examples of silica compounds other than the phyllosilicate mineral include wollastonite and glass bead.

Examples of the silica alumina compound include zeolite and mullite.

Examples of the aluminium compound include spinel, aluminum hydroxide, aluminium oxide (alumina), and aluminum borate.

Examples of the calcium compound include calcium carbonate.

Examples of the nitride include silicon nitride and boron nitride.

The water-insoluble inorganic compounds may be used alone or in combination of two or more thereof. In the case of using coal ash, it is preferred to use coal ash in combination with a water-insoluble inorganic compound other than coal ash.

The properties of the heat emission layer of the resulting heat dissipation film vary depending on the average particle size of the water-insoluble inorganic compound. Thus, it is preferred to use a water-insoluble inorganic compound with a selected particle size.

The lower limit of the average particle size of the water-insoluble inorganic compound is preferably 0.1 µm, and the upper limit thereof is preferably 50 µm. The lower limit of the average particle size of the water-insoluble inorganic compound is more preferably 0.2 µm, still more preferably 0.5 µm. The upper limit thereof is more preferably 40 µm, still more preferably 30 µm.

The average particle size of the water-insoluble inorganic compound can be determined by measuring the particle size distribution using a device such as a laser diffraction particle size distribution analyzer.

As for the amount of the water-insoluble inorganic compound in the heat emission layer, the lower limit is 30% by weight and the upper limit is 90% by weight relative to the total weight of the heat emission layer. When the amount of the water-insoluble inorganic compound is less than 30% by weight, the resulting heat dissipation film is highly flammable or has poor heat dissipation properties. When the amount of the water-insoluble inorganic compound is more than 90% by weight, coating unevenness tends to occur when a dispersion for heat emission layers (described later) is spread on a metal film, a substrate, or the like, which may result in loss of electrical insulation at a portion where the heat emission layer is thin. The lower limit of the amount of the water-insoluble inorganic compound is preferably 35% by weight, more preferably 40% by weight, still more preferably 50% by weight, particularly preferably 60% by weight. The upper limit thereof is preferably 85% by weight, more preferably 80% by weight, still more preferably 70% by weight.

The heat emission layer of the heat dissipation film of the present invention contains a heat-resistant synthetic resin.

The heat-resistant synthetic resin refers to a so-called "super engineering plastic". Specific examples include a polyimide resin, a polyamideimide resin, a fluororesin, a polyphenylene sulfide resin, a polysulfone resin, a polyarylate resin, a polyethersulfone resin, a polyetherimide resin, a polyether ether ketone resin, a polybenzoxazole resin, and a polybenzimidazole resin. Among these, at least one of a polyimide resin or a polyamideimide resin is preferably used because these resins are excellent in film-forming properties and heat resistance.

In view of heat resistance, the heat-resistant synthetic resin preferably has a structure free of saturated cyclic hydrocarbons such as cyclohexane ring. In addition, the heat-resistant synthetic resin is more preferably one having a structure with an aromatic ring, and is still more preferably at least one of an aromatic polyimide resin or an aromatic polyamideimide resin, because the resulting heat dissipation film will be particularly excellent in heat resistance.

The polyimide resin is a compound having a repeating structure represented by the following formula (1), and the polyamideimide resin is a compound having a repeating structure represented by the following formula (2).

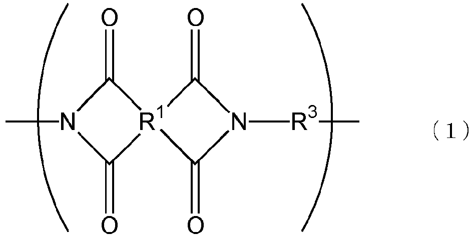

In the formula (1), R¹ is a tetravalent organic group having one or two benzene rings. In particular, R¹ preferably has a structure represented by any of the following formulas (3). When R¹ has a structure represented by any of the following formulas (3), the polyimide resin may have one of the structures represented by the following formulas (3) as R¹, or may be a copolymer having two or more of these structures represented by the following formulas (3) as R¹s.

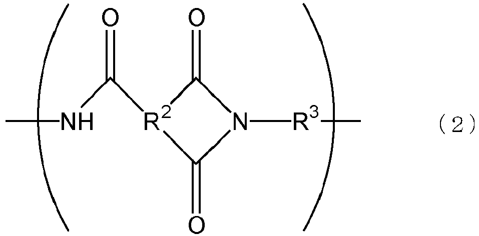

In the formula (2), R² is a trivalent organic group having one or two benzene rings. In particular, R² preferably has a structure represented by any of the following formulas (4). When R² has a structure represented by any of the following formulas (4), the polyamideimide resin may have one of the structures represented by the following formulas (4) as R², or may be a copolymer having two or more of these structures represented by the following formulas (4) as R²s.

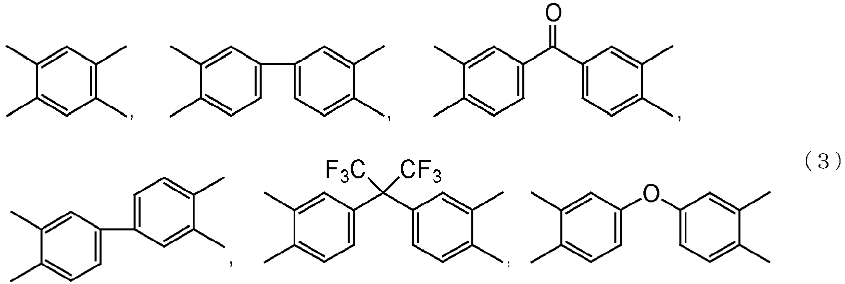

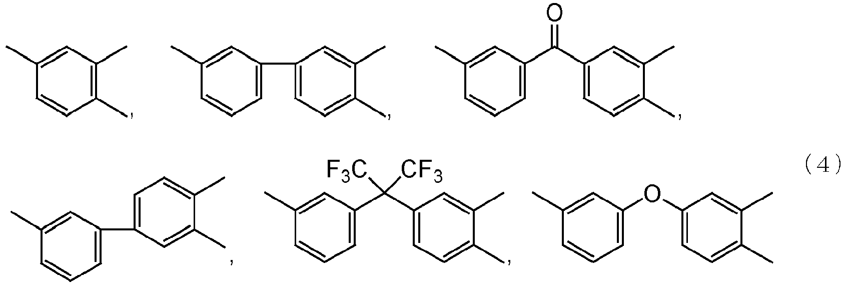

In the formula (1) and the formula (2), R³ is a divalent organic group having one or two benzene rings. In particular, R³ preferably has a structure represented by any of the following formulas (5). When R³ has a structure represented by any of the following formulas (5), the polyimide resin and the polyamideimide resin each may be one having one of the structures represented by the following formulas (5) as R³, or each may be a copolymer having two or more of these structures represented by the following formulas (5) as R³s.

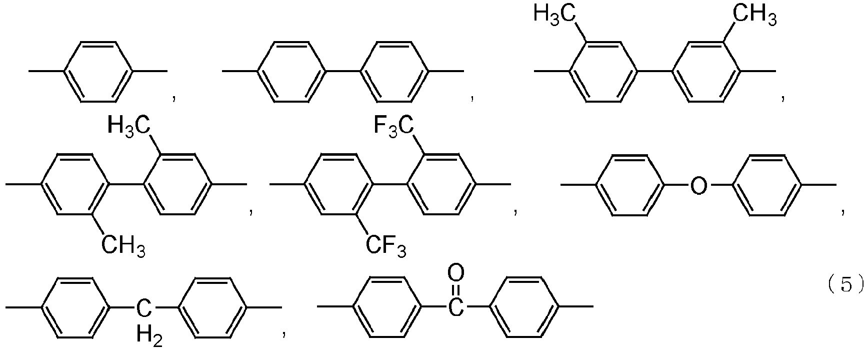

In particular, R¹, R², and R³ preferably have structures represented by the following formulas (6) because the heat emission layer of the resulting heat dissipation film will be provided with high mechanical strength at low cost. The polyimide resin may have one of the structures represented by the following formulas (6) as R¹ and one of the structures represented by the following formulas (6) as R³, or may be a copolymer having two or more of these structures represented by the following formulas (6) as R¹s and two or more these structures represented by the following formulas (6) as R³s. The polyamideimide resin may have one of the structures represented by the following formulas (6) as R² and one of the structures represented by the following formulas (6) as R³, or may be a copolymer having two or more of these structures represented by the following formulas (6) as R²s and two or more of these structures represented by the following formulas (6) as R³s.

In addition, the heat-resistant synthetic resin may be a copolymer formed from at least two of the polyimide resin and the polyamideimide resin.

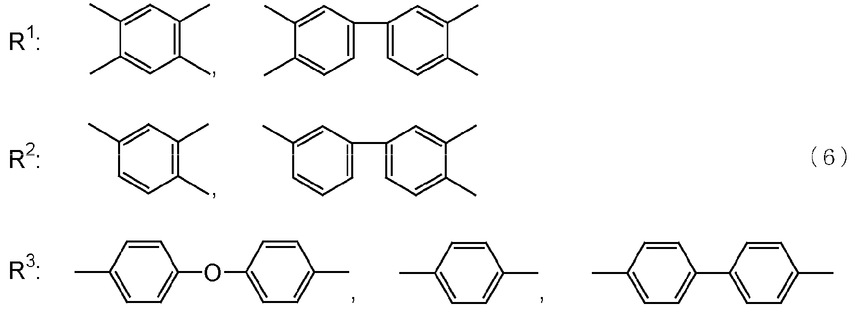

The heat emission layer may contain a coloring agent in view of design.

Examples of the coloring agent include inorganic pigments and organic pigments. In particular, inorganic pigments are preferred in view of heat resistance.

The inorganic pigments preferably contain at least one selected from the group consisting of carbon black, oxide pigments, hydroxide pigments, sulfide pigments, inorganic salt pigments, metal powder pigments, and composite oxide pigments.

The carbon black is composed of fine particles consisting mainly of carbon. Although the type is not particularly limited, furnace black produced by the furnace method is preferably used.

Examples of the oxide pigment include iron oxide, chromium oxide, titanium dioxide, zinc oxide, ultramarine, and cobalt blue.

Examples of the hydroxide pigment include alumina white, yellow iron oxide, and viridian.

Examples of the sulfide pigment include zinc sulfide, lithopone, cadmium yellow, vermilion, and cadmium red.

Examples of the inorganic salt pigment include chrome yellow, molybdate orange, zinc chromate, strontium chromate, sedimentary barium sulfate, baryta powder, calcium carbonate, and white lead.

Examples of the metal powder pigment include copper, iron, and aluminium.

The composite oxide pigment is a single compound synthesized by uniformly mixing several high-purity metal oxides at a high temperature.

As for the amount of the coloring agent, the lower limit is preferably 0.2% by weight and the upper limit is preferably 15% by weight relative to the total weight of the heat emission layer. When the amount of the coloring agent is less than 0.2% by weight, the heat emission layer may not be sufficiently colored.

When carbon black is used as the coloring agent, the upper limit of the amount of the carbon black is preferably 5% by weight. When the amount of the carbon black is more than 5% by weight, the resulting heat dissipation film may have poor electrical insulation.

The heat emission layer may contain a coupling agent such as a silane coupling agent or a titanate coupling agent to increase the mechanical strength.

Examples of the silane coupling agent include amino silane coupling agents, ureide silane coupling agents, vinyl silane coupling agents, methacrylic silane coupling agents, epoxy silane coupling agents, mercapto silane coupling agents, and isocyanate silane coupling agents.

Examples of the titanate coupling agent include titanate coupling agents having an alkylate group containing at least 1 to 60 carbon atoms, titanate coupling agents having an alkyl phosphite group, titanate coupling agents having an alkyl phosphate group, and titanate coupling agents having an alkyl pyrophosphate group.

The coupling agent may be mixed with the water-insoluble inorganic compound to exert its action in advance, or may be mixed with the dispersion for heat emission layers (described later).

As for the amount of the coupling agent, the lower limit is preferably 0.1% by weight and the upper limit is preferably 3.0% by weight relative to the total weight of the water-insoluble inorganic compound. When the amount of the coupling agent is less than 0.1% by weight, the effect of the use of the coupling agent may not be sufficiently exerted. When the amount of the coupling agent is more than 3.0% by weight, the effect may not correspond to the amount used. The lower limit of the amount of the coupling agent is more preferably 0.5% by weight, and the upper limit thereof is more preferably 2.0% by weight.

The thermal emissivity of the heat emission layer is at least 0.8, preferably at least 0.85, still more preferably at least 0.9.

The "thermal emissivity" can be measured using a thermal emissivity meter such as TSS-5X (Japan Sensor Corporation).

In view of application to electronic devices, the dielectric breakdown strength of the heat emission layer is at least 10 kV/mm, preferably at least 15 kV/mm, more preferably at least 20 kV/mm.

The "dielectric breakdown strength" can be measured using a dielectric breakdown tester such as HAT-300 (Hitachi Chemical Co., Ltd.) by a method according to ASTM D 149.

The heat emission layer is preferably classified as 0 to 2, more preferably 0 or 1, for adhesion with the metal film used as the heat transfer layer, as determined by a cross-cut test according to JIS K 5600. The adhesion classification is described in Table 1.

The adhesion of the heat emission layer with a metal film as the heat transfer layer can be adjusted by suitably changing the types and amounts of the water-insoluble inorganic compound and the heat-resistant synthetic resin according to the type of the metal film. For example, in the case where the metal film is an aluminium film, preferably, the heat emission layer contains a polyimide resin or a polyamideimide resin as the heat-resistant synthetic resin and contains 30 to 90% by weight of a phyllosilicate mineral as the water-insoluble inorganic compound.

**[Table 1]**

| Classification | Description |
|---|---|
| 0 | The edges of the cuts are completely smooth, none of the cells of the grid is detached. |
| 1 | Detachment of small flakes of the coating at the intersections of the cuts. A cross cut area not significantly greater than 5% is affected. |
| 2 | The coating has flaked along the edges and/or at the intersections of the cuts. A cross cut area significantly greater than 5%, but not significantly greater than 15%, is affected. |
| 3 | The coating has flaked along the edges of the cuts partly or wholly in large ribbons, and/or it has flaked partly or wholly on different parts of the cells. A cross cut area significantly greater than 15%, but not significantly greater than 35%, is affected. |
| 4 | The coating has flaked along the edges of the cuts in large ribbons and/or some cells have detached partly or wholly. A cross cut area not significantly greater than 35% is affected. |
| 5 | Any degree of flaking that cannot be classified even by classification 4. |

The heat emission layer is preferably classified as VTM-0 for flammability, as determined by the UL-94 vertical flammability test for thin materials (VTM test). The VTM test is carried out by rolling a film specimen into a cylinder, mounting the rolled specimen vertically to a clamp and applying 20-mm size flame to the specimen for three seconds twice, and determining the flammability of the specimen from its burning behavior based on the criteria shown in Table 2.

The thickness of the heat emission layer of the heat dissipation film for the UL-94 VTM test is preferably 100 µm or less.

**[Table 2]**

| | | Flammability Classification | | |
|---|---|---|---|---|
| | | VTM-O | VTM -1 | VTM-2 |
| Criteria | Burning time of each specimen | ≤ 10 sec | ≤ 30 sec | ≤ 30 sec |
| | Total burning time of 5 specimens | ≤ 50 sec | ≤ 250 sec | ≤ 250 sec |
| | Burning + glowing time of each specimen | ≤ 30 sec | ≤ 60 sec | ≤ 60 sec |
| | Burning to clamp | Not occurred | Not occurred | Not occurred |
| | Cotton ignition by flaming drips | Not occurred | Not occurred | Occurred |

The heat emission layer is preferably classified as V-0 for flammability, as determined by the UL-94 vertical flammability test (V test). The V test is carried out by mounting a specimen vertically to a clamp and applying 20-mm size flame to the specimen for 10 seconds twice, and determining the flammability of the specimen from its burning behavior based on the criteria shown in Table 3.

**[Table 3]**

| | | Flammability Classification | | |
|---|---|---|---|---|
| | | V-0 | V-1 | V-2 |
| Criteria | Burning time of each specimen | ≤ 10 sec | ≤ 30 sec | ≤ 30 sec |
| | Total burning time of 5 specimens | ≤ 50 sec | ≤ 250 sec | ≤ 250 sec |
| | Burning + glowing time of each specimen | ≤ 30 sec | ≤ 60 sec | ≤ 60 sec |
| | Burning to clamp | Not occurred | Not occurred | Not occurred |
| | Cotton ignition by flaming drips | Not occurred | Not occurred | Occurred |

Additionally, the heat emission layer is preferably classified as 5V-A or 5V-B for flammability, as determined by the UL-94 125-mm vertical flammability test (5V test). The 5V test is carried out by mounting a strip specimen vertically to a clamp and applying 125-mm size flame to the specimen for five seconds five times, and the flammability of the specimen is determined from its burning behavior. Further, a flat plate specimen is horizontally held, and 125-mm size flame is applied to the specimen from the bottom for five seconds five times, and the flammability of the specimen is determined from its burning behavior based on the criteria shown in Table 4.

**[Table 4]**

| | | Flammability Classification | |
|---|---|---|---|
| | | 5V-A | 5V-B |
| Criteria | Burning + glowing time of each strip specimen after the 5th flame application | ≤ 30 sec | ≤ 60 sec |
| | Cotton ignition by flaming drips from strip specimen | Not occurred | Not occurred |
| | Presence of hole after flame application (sheet specimen) | No | Yes |

As for the thickness of the heat emission layer, the lower limit is preferably 20 µm and the upper limit is preferably 100 µm. When the thickness of the heat emission layer is less than 20 µm, a decrease may occur in heat dissipation and electrical insulation. When the thickness of the heat emission layer is more than 100 µm, the emission efficiency relative to the thickness of the heat emission layer may be degraded. The lower limit of the thickness of the heat emission layer is more preferably 30 µm.

The heat emission layer may be laminated on one side of the heat transfer layer or on both sides of the heat transfer layer. In the case where the heat emission layer is laminated on one side of the heat transfer layer, an insulating layer for providing electrical insulation may be laminated on the other side of the heat transfer layer.

The insulating layer may be one containing the water-insoluble inorganic compound and the heat-resistant synthetic resin, as is the case with the heat emission layer.

As for the amount of the water-insoluble inorganic compound in the insulating layer, the lower limit is preferably 30% by weight and the upper limit is preferably 90% by weight relative to the total weight of the insulating layer. When the amount of the water-insoluble inorganic compound is less than 30% by weight, the resulting heat dissipation film may have high flammability or poor heat dissipation properties. When the amount of the water-insoluble inorganic compound is more than 90% by weight, coating unevenness tends to occur when a dispersion for insulating layers is spread on a metal film, a substrate, or the like, which may result in loss of electrical insulation at a portion where the insulating layer is thin. The lower limit of the amount of the water-insoluble inorganic compound is more preferably 50% by weight, and the upper limit thereof is more preferably 60% by weight.

As for the thickness of the insulating layer, the lower limit is preferably 20 µm and the upper limit is preferably 100 µm. When the thickness of the insulating layer is less than 20 µm, a decrease in electrical insulation may occur. When the thickness of the insulating layer is more than 100 µm, the electrical insulation efficiency relative to the thickness of the insulating layer may be degraded. The lower limit of the thickness of the insulating layer is more preferably 30 µm.

The heat dissipation film of the present invention preferably exhibits a cooling temperature of at least 15°C when the heat dissipation film having the same area as a 2. 4-cm square, 0.5- to 1.5-mm-thick ceramic heater is placed on the top of the ceramic heater generating heat with a 3 W power supply. When the cooling temperature is lower than 15°C, the heat dissipation film may not exhibit sufficient heat dissipation efficiency.

The cooling temperature is determined as follows: a power of 3 W is supplied to a ceramic heater without a heat dissipation film thereon until the temperature reaches equilibrium (i.e., heat generation temperature) ; a heat dissipation film is placed on the ceramic heater and a power of 3 W is supplied to the ceramic heater until the temperature reaches equilibrium (film set temperature); and the film set temperature is subtracted from the heat generation temperature to determine the difference in temperature, which is referred to as the cooling temperature.

The 2.4-cm square, 0.5- to 1.5-mm-thick ceramic heater maybe a commercial product such as BPC 10 (BI Technologies Japan Ltd.).

In a bend test by a cylindrical mandrel method according to JIS K 5600-5-1 (1999), the mandrel diameter at which cracking occurs for the first time in the heat emission layer of the heat dissipation film of the present invention is preferably 10 mm or less. When the mandrel diameter at which cracking occurs is more than 10 mm, the heat dissipation film may have poor flexibility. The mandrel diameter at which cracking occurs in the heat emission layer is more preferably 8 mm or less, still more preferably 5 mm or less.

The tensile strength of the heat dissipation film of the present invention is preferably at least 25 N/mm². When the tensile strength is less than 25 N/mm², the film is easily broken and difficult to handle. The tensile strength is more preferably at least 50 N/mm², still more preferably at least 70 N/mm.

The tensile strength is a value determined by a measurement method according to JIS K 7127-1, and is determined using a table-top type precision universal tester "AGS-X" (available from Shimadzu Corporation) with a distance between chucks of 80 mm and a tensile speed of 5 mm/min.

The heat dissipation film of the present invention has excellent water vapor barrier properties because the heat transfer layer is made of a metal film. Specifically, the water vapor permeability of the heat dissipation film of the present invention at 40°C and 90% RH is preferably lower than 0.01 g/m²·day.

The "water vapor permeability" can be measured using a gas and water vapor permeation analysis system available from GTR Tec Corporation or the like.

The heat dissipation film of the present invention may have any shape, such as a flat plate shape, a ring shape, or a U shape, suitable to the target of heat dissipation (i.e., heat source) and the heat dissipation method.

The heat emission layer of the heat dissipation film of the present invention can be produced by using a dispersion for heat emission layers which contains a dispersion medium and nonvolatile components including a water-insoluble inorganic compound and at least one of a heat-resistant synthetic resin or a heat-resistant synthetic resin precursor, wherein the amount of the water-insoluble inorganic compound is in the range of 30 to 90% by weight relative to the total weight of the nonvolatile components, and the amount of the nonvolatile components is more than 18% by weight and not more than 65% by weight relative to the total weight of the dispersion for heat emission layers. Such a dispersion for heat emission layers is also encompassed by the present invention.

The present inventors used a dispersion for heat emission layers in which the amount of the nonvolatile components and the proportion of the water-insoluble inorganic compound in the nonvolatile components were in specific ranges. As a result, the present inventors have found that it is possible to produce a heat dissipation film including a heat emission layer excellent in heat dissipation by radiation, electrical insulation, adhesion with a metal film, and heat resistance (i.e., the heat dissipation film of the present invention), which could not be produced in the past.

In addition, since the dispersion for heat emission layers of the present invention is prepared with an inexpensive water-insoluble inorganic compound, the resulting heat dissipation film has high productivity.

As used herein, the term "nonvolatile components" refers to any component that does not have a boiling point or that has a boiling point of 300°C or higher at normal pressure. The water-insoluble inorganic compound and the heat-resistant synthetic resin in the dispersion for heat emission layers of the present invention are the same as those contained in the heat dissipation film of the present invention. Thus, the description thereof is omitted.

Examples of the heat-resistant synthetic resin precursor include a polyamide acid. Imidization of the polyamide acid gives a polyimide resin or a polyamideimide resin. The polyamide acid can be imidized by, for example, thermal ring-closing or chemical ring-closing.

Thermal ring-closing imidization of the polyamide acid can be carried out by, for example, a method in which the polyamide acid is dispersed in a dispersion medium and heated at 120°C to 400°C for 0.5 to 10 hours.

In the case where the dispersion for heat emission layers of the present invention contains a heat-resistant synthetic resin precursor, the lower limit of the amount of the heat-resistant synthetic resin precursor is preferably 2% by weight and the upper limit thereof is preferably 45% by weight. When the amount of the heat-resistant synthetic resin precursor is less than 2% by weight, the resulting heat dissipation film may have poor electrical insulation. When the amount of the heat-resistant synthetic resin precursor is more than 45% by weight, the resulting heat dissipation film may have poor heat resistance. The lower limit of the amount of the heat-resistant synthetic resin precursor is more preferably 5% by weight, and the upper limit thereof is more preferably 30% by weight.

Examples of the dispersion medium include hydrocarbon solvents such as n-pentane, n-hexane, n-octane, and n-decane; alcohol solvents such as methanol, ethanol, 1-propanol, 2-propanol, 1-butanol, 2-butanol, isobutanol, tert-butanol, 1-pentanol, 2-pentanol, 1-hexanol, 2-hexanol, ethylene glycol, and propylene glycol; ketone solvents such as acetone, methyl ethyl ketone, diethyl ketone, methyl isobutyl ketone, and cyclohexanone; amide solvents such as N,N-dimethylformamide, N,N-dimethylacetamide, N,N-dimethylpropionamide, and N-methyl-2-pyrrolidone; ether solvents such as diethyl ether, methyl-tert butyl ether, dioxane, tetrahydrofuran, and cyclopentyl methyl ether; benzene solvents such as benzene, chlorobenzene, o-dichlorobenzene, m-dichlorobenzene, p-dichlorobenzene, toluene, o-xylene, p-xylene, ethylbenzene, phenol, p-chlorophenol, o-chlorophenol, and o-cresol; and sulfur-containing solvents such as dimethyl sulfoxide, dimethyl sulfone, and sulfolane. Water may be used as the dispersion medium in an amount that does not cause precipitation of additives. In particular, at least one selected from the group consisting of N-methyl-2-pyrrolidone, N,N-dimethylformamide, N,N-dimethylacetamide, dimethyl sulfoxide, tetrahydrofuran, and sulfolane is preferred because the heat-resistant synthetic resin will have high solubility. These dispersion media may be used alone or in combination of two or more thereof.

As for the amount of the water-insoluble inorganic compound in the dispersion for heat emission layers of the present invention, the lower limit is 30% by weight and the upper limit is 90% by weight relative to the total weight of the nonvolatile component. When the amount of the water-insoluble inorganic compound is less than 30% by weight, the heat emission layer of the resulting heat dissipation film becomes highly flammable. When the amount of the water-insoluble inorganic compound is more than 90% by weight, the dispersion becomes highly viscous. Consequently, loss of electrical insulation may occur at a portion where the heat emission layer is thin due to coating unevenness on the metal film of the heat emission layer. The lower limit of the amount of the water-insoluble inorganic compound is preferably 35% by weight, more preferably 40% by weight, still more preferably 50% by weight, particularly preferably 60% by weight. The upper limit thereof is preferably 85% by weight, more preferably 80% by weight, still more preferably 70% by weight.

The amount of the nonvolatile components in the dispersion for heat emission layers of the present invention is more than 18% by weight and not more than 65% by weight. When the amount of the nonvolatile components is not more than 18% by weight, the dispersion for heat emission layers becomes non-uniform, and thus a uniform film cannot be obtained. When the amount of the nonvolatile components is more than 65% by weight, the dispersion for heat emission layers becomes too viscous, making it difficult to form a film. The amount of the nonvolatile components is preferably more than 20% by weight and not more than 55% by weight, more preferably more than 25% by weight and not more than 45% by weight.

The proportion of the nonvolatile components in the dispersion for heat emission layers of the present invention can be determined from the weight of a solid residue resulting from the removal of a solvent by vacuum evaporation using a device such as a thermogravimetric analyzer (TG), a thermogravimetric/differential thermal analyzer (TG-DTA), or an evaporator.

The heat dissipation film of the present invention can be produced by a method including step (1-1) of mixing the dispersion medium and the nonvolatile components including a water-insoluble inorganic compound and at least one of a heat-resistant synthetic resin or a heat-resistant synthetic resin precursor to prepare the dispersion for heat emission layers of the present invention; step (1-2) of spreading the prepared dispersion for heat emission layers on a metal film that serves as a heat transfer layer, followed by standing still; and step (1-3) of removing the dispersion medium from the dispersion for heat emission layers spread on the metal film, forming a film, and obtaining a laminate film. Such a method for producing a heat dissipation film is also encompassed by the present invention.

The heat dissipation film of the present invention can also be produced by a method including step (2-1) of mixing the dispersion medium and the nonvolatile components including a water-insoluble inorganic compound and at least one of a heat-resistant synthetic resin or a heat-resistant synthetic resin precursor to prepare the dispersion for heat emission layers of the present invention; step (2-2) of spreading the prepared dispersion for heat emission layers on a substrate, followed by standing still; step (2-3) of removing the dispersion medium from the dispersion for heat emission layers spread on the substrate, forming a film, and separating the film from the substrate to obtain a film as a heat emission layer; and step (2-4) of adhesively laminating the film as a heat emission layer on the metal film as a heat transfer layer by hot pressing to obtain a laminate film. Such a method for producing a heat dissipation film is also encompassed by the present invention.

Hereinafter, the method including steps (1-1) to (1-3) and the method including steps (2-1) to (2-4) are also collectively simply referred to as "the method for producing a heat dissipation film of the present invention".

According to the method for producing a heat dissipation film of the present invention, in step (1-1) or (2-1), the dispersion medium and the nonvolatile components including a water-insoluble inorganic compound and at least one of a heat-resistant synthetic resin or a heat-resistant synthetic resin precursor are mixed to prepare the dispersion for heat emission layers of the present invention.

The mixing temperature in step (1-1) or (2-1) is not particularly limited, but the lower limit is preferably 10°C and the upper limit is preferably 40°C.

According to the method for producing a heat dissipation film of the present invention, in step (1-2) or (2-2), the dispersion for heat emission layers of the present invention is spread on a metal film or a substrate, followed by standing still.

In step (1-2) or (2-2), examples of the method for spreading the dispersion for heat emission layers of the present invention on a metal film or a substrate include a method for applying the dispersion for heat emission layers to form a film using a doctor blade, a bar coater, or the like.

In step (2-2), the substrate on which the dispersion is spread is preferably made of glass, polyethylene terephthalate, polyimide, polyethylene, or polypropylene, in view of the compatibility between the dispersion and the substrate, wettability, and releasability after drying.

In step (1-2) or (2-2), the thickness of the dispersion for heat emission layers of the present invention spread on a metal film or a substrate is preferably at least 30 µm. When the thickness of the dispersion for heat emission layers of the present invention is less than 30 µm, the heat emission layer of the resulting heat dissipation film may be too thin to maintain electrical insulation. The lower limit of the dispersion for heat emission layers of the present invention is more preferably 50 µm, still more preferably 100 µm.

In the method for producing a heat dissipation film of the present invention, in step (1-3) or (2-3), the dispersion medium is removed from the dispersion for heat emission layers spread on the metal film or the substrate. In step (1-3), the dispersion medium is removed and a film is formed. Thus, a laminate film is obtained. In addition, in step (2-3), the dispersion medium is removed, a film is formed, and the film is separated from the substrate. Thus, a film as a heat emission layer is obtained.

Instep (1-3) or (2-3), examples of the method for removing the dispersion medium from the dispersion for heat emission layers spread on the metal film or the substrate include various solid liquid separation methods such as centrifugation, filtration, vacuum drying, freeze vacuum drying, a heat evaporation method, and combinations of these methods. For example, in the case of a heat evaporation method among the above methods, the dispersion applied to the metal film or the substrate is dried in a forced air oven, while the metal film or the substrate is held horizontally, at 20°C to 150°C, preferably 30°C to 120°C, for about 0.5 to 24 hours, preferably 2 to 12 hours, whereby the dispersion medium can be removed.

In step (2-4), the film as a heat emission layer obtained in step (2-3) is adhesively laminated on the metal film as a heat transfer layer by hot pressing, whereby a laminate film can be obtained.

In step (2-4), in view of increasing the adhesion of the heat emission layer with the metal film, the heat-pressing temperature at which the film as a heat emission layer film is adhesively laminated on the metal film is preferably 50°C to 200°C, and the pressures is preferably 10 to 100 kgf/cm². The heat-pressing temperature is more preferably 100°C to 150°C.

In the case where the dispersion for heat emission layers of the present invention contains a heat-resistant synthetic resin precursor, the laminate film obtained in step (1-3) or (2-4) is further heated in an electric furnace or the like, whereby the heat dissipation film of the present invention can be obtained. Specifically, in the case where a polyamide acid is used as the heat-resistant synthetic resin precursor, the laminate film obtained as described above is heated at 120°C to 400°C for 0.5 to 10 hours, whereby a heat dissipation film having a heat emission layer containing polyimide as a heat-resistant synthetic resin can be obtained.

The heat dissipation film of the present invention is excellent in heat dissipation by heat transfer and radiation, electrical insulation, and flexibility, and is high in mechanical strength. Thus, the heat dissipation film is suitably used to dissipate heat generated by built-in IC chips or LEDs in electronic devices.

A solar cell including the heat dissipation film of the present invention is also encompassed by the present invention. The heat dissipation film of the present invention is excellent in moisture resistance, heat dissipation, and electrical insulation, and is high in mechanical strength. Thus, the solar cell of the present invention including the heat dissipation film of the present invention is also excellent in durability and weather resistance.

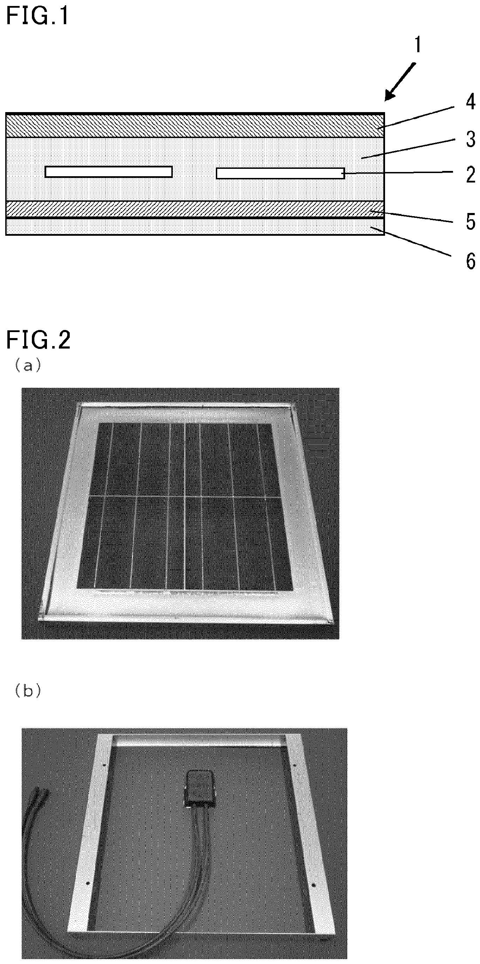

Fig. 1 is a schematic cross-sectional view illustrating an example of the solar cell of the present invention.

As illustrated in Fig. 1, a solar cell 1 of the present invention includes solar cell elements 2 for converting light energy into electric energy by photovoltaic effect. The solar cell elements 2 are enclosed by a sealing material 3. The solar cell 1 of the present invention includes a light-transmissive substrate 4 on the sunlight receiving side, and the heat dissipation film of the present invention (i.e., a laminate film formed by laminating a heat transfer layer 5 and a heat emission layer 6) on the side opposite to the light-transmissive substrate 4.

The solar cell elements 2 may be formed from any materials that can convert light energy into electric energy by photovoltaic effect. For example, monocrystalline silicon, polycrystalline silicon, amorphous silicon, and compound semiconductors (group III-V, group II-VI, and the like) can be used. Polycrystalline silicon is preferred among these.

Examples of the sealing material 3 include ethylene-vinyl acetate copolymers, ethylene-aliphatic unsaturated carboxylic acid copolymers, ethylene-aliphatic carboxylic acid ester copolymers, and saponified products of these copolymers.

Since the light-transmissive substrate 4 constitutes the outermost layer on the sunlight receiving side of the solar cell 1, the light-transmissive substrate 4 is preferably excellent in properties such as weather resistance, water repellence, contamination resistance, and mechanical strength in addition to transparency.

Examples of the light-transmissive substrate 4 include substrates made of a resin (e.g., polyester resin, fluororesin, acrylic resin, ethylene-vinyl acetate copolymer) and glass substrates. Glass substrates are preferred because they are excellent in weather resistance and impact resistance and can be produced at low cost. Fluororesin is also suitable because it is particularly excellent in weather resistance.

The method for producing the solar cell 1 of the present invention is not particularly limited. For example, the light-transmissive substrate 4, the sealing material 3 enclosing the solar cell elements 2, and the heat dissipation film of the present invention are stacked in the stated order, and are vacuum-laminated.

### - Advantageous Effects of Invention

According to the present invention, it is possible to provide a heat dissipation film having high mechanical strength and flexibility, which is obtained by laminating a heat emission layer excellent in heat dissipation by infrared radiation, electrical insulation, and heat resistance on a metal film having excellent heat transfer efficiency. The present invention can also provide a dispersion for heat emission layers for use in the production of the heat dissipation film, a method for producing a heat dissipation film using the dispersion for heat emission layers, and a solar cell including the heat dissipation film.

### BRIEF DESCRIPTION OF DRAWINGS

Fig. 1 is a schematic cross-sectional view illustrating an example of the solar cell of the present invention.
Fig. 2(a) is a photograph of the front side of a solar cell module produced using a heat dissipation film produced in an example; and Fig. 2(b) is a photograph of the back side of the solar cell module.

### DESCRIPTION OF EMBODIMENTS

The present invention is described in more detail below with reference to examples, but the present invention is not limited to these examples.

### (Example 1)

### (Synthesis of polyamide acid varnish)

A 2-L reaction vessel equipped with a stirrer and a thermometer was charged with 140.1 g (0.70 mol) of 4,4-diaminodiphenylether and 1433.3 g of
N-methyl-2-pyrrolidone, and these components were dissolved at 30°C to 40°C. Subsequently, 72.5 g (0.33 mol) of pyromellitic anhydride and 97.8 g (0.33 mol) of
3,3',4,4'-biphenyltetracarboxylic dianhydride were added to the reaction vessel over 40 minutes while the temperature was maintained at 45°C to 50°C. After stirring at the same temperature for 60 minutes, 183.3 g (0.02 mol) of a 2.4% by weight solution of pyromellitic anhydride in N-methyl-2-pyrrolidone was added to the reaction vessel to adjust the viscosity, and 7.5 g (0.002 mol) of a 4.2% by weight solution of phthalic anhydride in N-methyl-2-pyrrolidone was added thereto to terminate the reaction. Thus, 1933.9 g of polyamide acid varnish having a concentration of 16.3% and a viscosity of 6.2 Pa·s was obtained.

### (Preparation of dispersion for heat emission layers)

A plastic airtight container was charged with 6.0 g of talc ("Talc RA" available from Nippon Talc Co., Ltd.) and 24.5 g of the synthesized polyamide acid varnish (polyamide acid: 4.0 g; N-methyl-2-pyrrolidone: 20.5 g). These components were then stirred with a planetary centrifugal mixer ("ARE-310" available from Thinky Corporation) in a mixing mode (2000 rpm) for 10 minutes and in a deaeration mode (2200 rpm) for 10 minutes. Thus, a uniform dispersion for heat emission layers was obtained in which the proportion of the talc was 60.0% by weight relative to the total weight of the nonvolatile components and the proportion of the nonvolatile components was 32.8% by weight relative to the total weight of the dispersion.

### (Production of heat dissipation film)

The obtained dispersion for heat emission layers was applied with a bar coater having a groove depth of 200 µm to a 200-um-thick aluminium film having a smooth and rectangular bottom. The applied dispersion was dried in a forced air oven at 90°C for two hours while the aluminium film was held horizontally, whereby a film as a heat emission layer was formed on the aluminium film. The laminate film was heated at 120°C for 30 minutes, at 150°C for 5 minutes, at 200°C for 5 minutes, at 250°C for 5 minutes, and at 350°C for 60 minutes in the stated order, thus obtaining a heat dissipation film having a 49.2-µm-thick heat emission layer containing talc and a polyimide resin in which the amount of the water-insoluble inorganic compound (talc) was 60.0% by weight relative to the total weight of the heat emission layer.

### (Example 2)

A uniform dispersion for heat emission layers was obtained as in Example 1, except that 36.0 g of talc was added and 22.8 g of N-methyl-2-pyrrolidone was further added in "(Preparation of dispersion for heat emission layers) ". In the obtained dispersion for heat emission layers, the proportion of the talc was 90.0% by weight relative to the total weight of the nonvolatile components, and the proportion of the nonvolatile components was 48.0% by weight relative to the total weight of the dispersion.

A heat dissipation film having a 57.6-µm-thick heat emission layer containing talc and a polyimide resin was obtained using the obtained dispersion for heat emission layers as in Example 1, except that a bar coater with a groove depth of 100 µm was used. The amount of the water-insoluble inorganic compound (talc) was 90.0% by weight relative to the total weight of the heat emission layer.

### (Example 3)

A uniform dispersion for heat emission layers was obtained as in Example 1, except that 1.7 g of talc was added in " (Preparation of dispersion for heat emission layers) ". The proportion of the talc was 30.0% by weight relative to the total weight of the nonvolatile components, and the proportion of the nonvolatile components was 21.8% by weight relative to the total weight of the dispersion.

A heat dissipation film having a 43.6-µm-thick heat emission layer containing talc and a polyimide resin was obtained using the obtained dispersion for heat emission layers as in Example 1, except that the dispersion was applied with a bar coater having a groove depth of 200 µm, the dispersion medium was removed by drying in a forced air oven at 90°C for 30 minutes, and the dispersion was further applied to the same surface with a bar coater having a groove depth of 150 µm. The amount of the water-insoluble inorganic compound (talc) was 30.0% by weight relative to the total weight of the heat emission layer.

### (Example 4)

A plastic airtight container was charged with 3.0 g of talc ("Talc RA" available from Nippon Talc Co., Ltd.), 3.0 g of coal ash ("Clean Ash" available from Soma Environment Service Corporation), 0.2 g of carbon black ("MA-100" available from Mitsubishi Chemical Corp.), and 24.5 g of the polyamide acid varnish (polyamide acid: 4.0 g; N-methyl-2-pyrrolidone: 20.5 g) synthesized in Example 1. These components were mixed under stirring as in "(Preparation of dispersion for heat emission layers)" of Example 1. Thus, a uniform dispersion for heat emission layers was obtained in which the total proportion of the talc, coal ash, and coloring agent (carbon black) was 60.8% by weight relative to the total weight of the nonvolatile components and the proportion of the nonvolatile components was 33.2% by weight relative to the total weight of the dispersion.

A heat dissipation film having a 49.2-µm-thick heat emission layer containing talc, coal ash, carbon black, and a polyimide resin was obtained using the obtained dispersion for heat emission layers as in Example 1. The total amount of the talc, coal ash, and coloring agent (carbon black) was 60.8% by weight relative to the total weight of the heat emission layer.

### (Example 5)

A plastic airtight container was charged with 6.0 g of non-swelling mica ("SJ-010" available from Yamaguchi Mica Co., Ltd.) and 24.5 g of the polyamide acid varnish (polyamide acid: 4.0 g; N-methyl-2-pyrrolidone: 20.5 g) synthesized in Example 1. Further, 2.8 g of N-methyl-2-pyrrolidone was added thereto. These components were mixed under stirring as in " (Preparation of dispersion for heat emission layers)" of Example 1. Thus, a uniform dispersion for heat emission layers was obtained in which the proportion of the water-insoluble inorganic compound was 60.0% by weight relative to the total weight of the nonvolatile components and the proportion of the nonvolatile components was 30.0% by weight relative to the total weight of the dispersion.

A heat dissipation film having a 45.0-µm-thick heat emission layer containing non-swelling mica and a polyimide resin was obtained using the obtained dispersion for heat emission layers as in Example 1. The amount of the water-insoluble inorganic compound (non-swelling mica) was 60.0% by weight relative to the total weight of the heat emission layer.

### (Comparative Example 1)

A plastic airtight container was charged with 6.0 g of talc ("Talc RA" available from Nippon Talc Co., Ltd.), 24.5 g of the polyamide acid varnish (polyamide acid: 4.0 g; N-methyl-2-pyrrolidone: 20.5 g) synthesized in Example 1, and 25.1 g of N-methyl-2-pyrrolidone, and these components were mixed under stirring as in " (Preparation of dispersion for heat emission layers)" of Example 1 in such a manner that the proportion of the talc was 60.0% by weight relative to the total weight of the nonvolatile components and that the proportion of the nonvolatile components was 18.0% by weight relative to the total weight of the dispersion. The talc deposited several minutes after standing still, and thus a uniform dispersion could not be obtained.

Further, an attempt was made to produce a film as in Example 1; however, the talc deposited, and thus a uniform film could not be obtained.

### (Comparative Example 2)

A plastic airtight container was charged with 24.5 g of the polyamide acid varnish (polyamide acid: 4.0 g;
N-methyl-2-pyrrolidone: 20.5 g) synthesized in Example 1, and put in an oven at 90°C to evaporate the solvent until the total amount was 10.8 g. Thus, a 37.0% by weight solution of a polyamide acid in N-methyl-2-pyrrolidone (polyamide acid: 4.0 g; N-methyl-2-pyrrolidone: 6.8 g) was obtained. To the solution was added 9.3 g of talc ("Talc MS-K" available from Nippon Talc Co., Ltd.), followed by mixing under stirring as in "(Preparation of dispersion for heat emission layers)" of Example 1. Thus, a uniform dispersion for heat emission layers was obtained in which the amount of the water-insoluble inorganic compound (talc) was 70.0% by weight relative to the total weight of the nonvolatile components and the amount of the nonvolatile components was 66.2% by weight relative to the total weight of the dispersion.

The obtained dispersion for heat emission layers had little fluidity, and thus could not be applied to a substrate. Thus, a heat dissipation film could not be produced.

### (Comparative Example 3)

### (Synthesis of polyamide acid varnish)

A 500-mL reaction vessel equipped with a stirrer and a thermometer was charged with 29.4 g (0.10 mol) of
3,3',4,4'-biphenyltetracarboxylic dianhydride and 80.8 g of N,N-dimethylacetamide, and these components were dissolved at room temperature. Then, the solution was cooled to 0°C, and a mixture of 21.0 g (0.10 mol) of
4,4-diaminodicyclohexylmethane and 37.0 g of
N,N-dimethylacetamide was added to the solution at 0°C to 25°C over 2 hours. Subsequently, the mixture was stirred at room temperature for one week, and 0.7 g (0.0002 mol) of a 4.2% by weight solution of phthalic anhydride in N,N-dimethylacetamide was added to the mixture to terminate the reaction. Thus, 168.9 g of polyamide acid varnish having a concentration of 29.8% and a viscosity of 10 Pa·s was obtained.

### (Production of heat dissipation film)

A plastic airtight container was charged with 30.7 g of the synthesized polyamide acid varnish (polyamide acid: 9.1 g; N-methyl-2-pyrrolidone: 21.6 g), followed by deaeration in a deaeration mode (2200 rpm) for 10 minutes using a planetary centrifugal mixer. Then, a heat dissipation film having a 65.2-µm-thick heat emission layer free of a water-insoluble inorganic compound was obtained as in "(Preparation of dispersion for heat emission layers)" of Example 1, except that the polyamide acid varnish was applied to a substrate to a thickness of 250 µm using a doctor blade.

### (Comparative Example 4)

A plastic airtight container was charged with 3.0 g of talc ("Talc RA" available from Nippon Talc Co., Ltd.), 3.0 g of coal ash ("Clean Ash" available from Soma Environment Service Corporation), 2.0 g of carbon black, 24.5 g of polyamide acid varnish (polyamide acid: 4.0 g; N-methyl-2-pyrrolidone: 20.5 g) synthesized in Example 1, and 4.5 g of NMP. These components were mixed under stirring as in Example 1. Thus, a uniform dispersion for heat emission layers was obtained in which the amount of the water-insoluble inorganic compound (talc + coal ash) and the coloring agent (carbon black) was 66.7% by weight relative to the total weight of the nonvolatile components, and the amount of the nonvolatile components was 32.4% by weight relative to the total weight of the dispersion.

A heat dissipation film having a 48.6-µm-thick heat emission layer containing talc and polyimide resin was obtained using the obtained dispersion for heat emission layers as in Example 1. The amount of the water-insoluble inorganic compound (talc + coal ash) and the coloring agent (carbon black) was 66.7% by weight relative to the total weight.

### (Comparative Example 5)

Cerac α (available from Ceramission Co., Ltd.) in a liquid form containing a mixture of materials such as silicon oxide and aluminium oxide and a silicone resin as a binder was applied with a bar coater to a 200-um-thick aluminium film having a smooth and rectangular bottom (i.e., a heat transfer layer) to a thickness of 50 µm. The coating was dried in a forced air oven at 90°C for one hour while the aluminium film was held horizontally, whereby a heat emission layer was formed on the aluminium film. This laminate film was heated at 120°C for 20 minutes to obtain a heat dissipation film having a 50.0-µm-thick heat emission layer containing a mixture of materials such as silicon oxide and aluminium oxide and a silicone resin. The amount of the water-insoluble inorganic compound (mixture of silicon oxide and aluminium oxide) was 56.0% by weight relative to the total weight of the heat emission layer.

### (Comparative Example 6)

A heat dissipation film having a 49.2-µm-thick heat emission layer containing talc and a polyimide resin was obtained as in Example 1, except that a 135-µm-thick graphite sheet (available from Japan Matex Co. Ltd.) was used as the heat transfer layer instead of the 200-um-thick aluminium film in "(Production of heat dissipation film)". The amount of the water-insoluble inorganic compound (talc) was 60.0% by weight relative to the total weight of the heat emission layer.

Table 5 shows the composition of each of the dispersions for heat emission layers prepared in Examples 1 to 5 and Comparative Examples 1 to 4, the portion of the nonvolatile components relative to the total weight of the dispersion, and the portion of the water-insoluble inorganic compound relative to the total weight of the nonvolatile components.

**[Table 5]**

| | | | | | Example 1 | Example 2 | Example 3 | Example 4 | Example 5 |
|---|---|---|---|---|---|---|---|---|---|
| Dispersion for heat emission layers | Composition (parts by weight) | Nonvolatile components | Water-insoluble inorganic compound | Talc | 6. 0 | 36.0 | 1. 7 | 3. 0 | - |
| | | | | Coal ash | - | - | - | 3. 0 | - |
| | | | | Non-swelling mica | - | - | - | - | 6. 0 |
| | | | Coloring agent | Carbon black | - | - | - | 0.2 | - |
| | | | Heat-resistant synthetic resin precursor | Polyamide acid | 4. 0 | 4. 0 | 4. 0 | 4. 0 | 4. 0 |
| | | Dispersion medium | | N-methyl-2-pyrrolidone | 20. 5 | 43. 3 | 20. 5 | 20. 5 | 23. 3 |
| | Amount of nonvolatile components relative to the total weight of the dispersion (wt%) | | | | 32. 8 | 48.0 | 21. 8 | 33. 2 | 30. 0 |
| | Amount of water-insoluble inorganic compound and coloring agent relative to the total weight of nonvolatile components (wt%) | | | | 60. 0 | 90.0 | 30. 0 | 60. 8 | 60. 0 |

| | | | | | | Comparative Example 1 | Comparative Example 2 | Comparative Example 3 | Comparative Example 4 |
|---|---|---|---|---|---|---|---|---|---|
| | Dispersion for heat emission layers | Composition (parts by weight) | Nonvolatile components | Water-insoluble inorganic compound | Talc | 6. 0 | 9. 3 | - | 3. 0 |
| | | | | | Coal ash | - | - | - | 3. 0 |
| | | | | | Non-swelling mica | - | - | - | - |
| | | | | Coloring agent | Carbon black | - | - | - | 2. 0 |
| | | | | Heat-resistant synthetic resin precursor | Polyamide acid | 4. 0 | 4. 0 | 9. 1 | 4. 0 |
| | | | Dispersion medium | | N-methyl-2-pyrrolidone | 45. 6 | 6. 8 | 21. 6 | 25. 0 |
| | | Amount of nonvolatile components relative to the total weight of the dispersion (wt%) | | | | 18.0 | 66. 2 | 29. 8 | 32. 4 |
| | | Amount of water-insoluble inorganic compound and coloring agent relative to the total weight of nonvolatile components (wt%) | | | | 60.0 | 70.0 | 0 | 66. 7 |

### <Evaluation>

The heat dissipation films obtained in the examples and the comparative examples were evaluated as follows. For the evaluation of the thermal emissivity, dielectric breakdown strength, adhesion, and flammability, only a heat emission layer of a heat dissipation film was produced and evaluated.

The following evaluation was not carried out for Comparative Example 1 and Comparative Example 2 in which a heat dissipation film could not be produced.

Table 6 shows the results.

### (Thermal emissivity)

The thermal emissivity was measured using a thermal emissivity meter "TSS-5X" available from Japan Sensor Corporation.

### (Dielectric breakdown strength)

The dielectric breakdown voltage (kV) was measured by a method according to ASTM D 149 using a dielectric breakdown tester "HAT-300" available from Hitachi Chemical Co., Ltd., and the dielectric breakdown strength (kV/mm) was calculated.

### (Adhesion)

The heat emission layer of each obtained heat dissipation film was subjected to a cross-cut test according to JIS K 5600. The heat emission layer was cut to form a square grid with 25 cells using a single-blade cutting tool, and a transparent adhesive tape was applied to the grid. Then, the tape was unfailingly peeled off at an angle close to 60° within 0.5 to 1.0 seconds. The degree of peeling of the heat emission layer on the grid area was visually categorized in six levels from 0 to 5, with 0 being the least degree of peeling, according to Table 1.

### (Flammability classification based on VTM test)

The heat emission layer of the resulting heat dissipation film was subjected to the UL-94 vertical flammability test for thin materials (VTM test).

Five specimens (length: about 200 mm; width: 50 mm) of each heat emission layer were used for each criterion shown in Table 2. The size of flame was 20 mm.

The flame application time was three seconds, and the afterflame time after flame application was measured for each specimen. As soon as the fire was out, the second flame application was carried out for three seconds, and the afterflame time after flame application was measured for each specimen as in the first measurement. Further, whether or not the cotton placed below the specimen was ignited by flaming drips from the specimen was observed at the same time. The benchmark was at a position 125 mm from the bottom of the specimen, and the marking cotton was placed 300 mm below the bottom of the specimen.

As for the flammability classification based on the VTM test, the degree of flame retardancy decreases as the number increases from VTM-1 to VTM-2, with VTM-0 being the most flame-retardant. Specimens not corresponding to any of the ranks of VTM-0 to VTM-2 were evaluated as "failed".

### (Flammability classification based on V test)

The heat emission layer of the resulting heat dissipation film was subjected to the UL-94 vertical flammability test (V test).

Five specimens (length: 127 mm; width: 13 mm) of each heat emission layer were used for each criterion shown in Table 3. The size of flame was 20 mm.

The flame application time was 10 seconds, and the afterflame time after flame application was measured for each specimen.

As soon as the fire was out, the second flame application was carried out for 10 seconds, and the afterflame time after flame application was measured for each specimen as in the first measurement. Further, whether or not the cotton placed below the specimen was ignited by flaming drips from the specimen was observed at the same time.

The flammability classification was determined based on the burning time in the first and second tests, ignition of the cotton, and the like according to the UL-94-V standard. As for the flammability classification based on the V test, the degree of flame retardancy decreases as the number decreases from V-1 to V-2, with V-0 being the most flame-retardant. Specimens not corresponding to any of the ranks of V-0 to V-2 were evaluated as "failed".

### (Flammability classification based on 5V test)

The heat emission layer of the resulting heat dissipation film was subjected to the UL-94 125-mm vertical flammability test (5V test).

Specimens (length: 127 mm; width: 13 mm) were used for each criteria shown in Table 4. The size of flame was 125 mm.

The flame application time was five seconds, and the afterflame time after flame application was measured for each specimen.

As soon as the fire was out, the second flame application was carried out for five seconds, and the afterflame time after flame application was measured for each specimen as in the first measurement. This procedure was repeated five times. Further, whether or not the cotton placed below the specimen was ignited by flaming drips from the specimen was observed at the same time.

The flammability classification was determined based on the burning time in the first to fifth tests, ignition of the cotton, and the like according to the UL-94-5V standard. Those that passed criteria were further subjected to a plate flammability test.

Plate specimens (length: 150 mm; width: 150 mm) were evaluated in a plate flammability test. The size of flame was 125 mm.

The flame application time was five seconds. As soon as the fire was out, the second flame application was carried out for five seconds. This procedure was repeated five times. The presence or absence of a hole was determined in each plate specimen after flame application. Those without a hole were evaluated as 5V-A, and those with a hole was evaluated as 5V-B.

### (Cooling temperature)

Each obtained heat dissipation film was evaluated for its cooling temperature by the following method.

A 2.4-cm square, 0.5- to 1.5-mm-thick ceramic heater ("BPC10" available from BI Technologies Japan Ltd.) (hereinafter also simply referred to as a "heater") placed on a substrate ("MODEL ICB-88G" available from Sunhayato Corp.) was placed in a plastic airtight container (body: polypropylene; lid: polyethylene; container size: 188 mm × 225 mm; distance from the ceramic heater to the lid: 18 mm). A coated electric wire was soldered to an end portion of the heater so as to connect the heater to a DC stabilized power supply ("AD-8724D" available from A&D Company, Limited). On a heat spot (12 mm × 19 mm) of the heater, an aluminium film (thickness: 1 mm) having the same area as the heat spot was placed in order to prevent contact between the soldered portion and the heat dissipation film. Also, polystyrene foam as a thermal insulating material was placed at the lower portion of the airtight container.

In this state, the output current of the DC stabilized power supply was adjusted to supply a power of 3 W to the heater, and the temperature in equilibrium (heat generation temperature (A)) was measured with a data logger. Next, a 2.4-cm square flat plate-like heat dissipation film was placed on a heater of the same type used for measurement of the heat generation temperature (A), and the temperature in equilibrium (film set temperature (B)) was measured. When placing the heat dissipation film, an appropriate amount of silicone grease ("SCH-20" available from Sunhayato Corp.) was applied to the heater so as to adhere the heat dissipation film to the heater. The difference in temperature (A-B) between the heat generation temperature (A) and the film set temperature (B) was evaluated as the cooling temperature.

The cooling temperature was also evaluated by the same procedure using a 200-um-thick aluminium film instead of the heat dissipation film.

### (Bending resistance)

Each obtained heat dissipation film was subjected to the bend (cylindrical mandrel method) test according to JIS K 5600-5-1. As for the test method, each one specimen was tested using 1- to 10-mm-diameter mandrels from a larger-diameter mandrel to a smaller-diameter mandrel to determine the mandrel diameter at which cracking occurs for the first time in the heat emission layer of the heat dissipation film. A film which did not crack with a 1-mm mandrel was ranked as ≤ 1 mm.

### (Tensile strength)

A specimen type 5 was produced from each obtained heat dissipation film according to JIS K 7127-1. A tensile test was carried out using a table-top type precision universal tester ("AGS-X" available from Shimadzu Corporation) with a distance between chucks of 80 mm and a tensile speed of 5 mm/min to measure the maximum tensile strength so as to determine the tensile strength (N/mm²).

### (Water vapor permeability)

The resulting heat dissipation film was subjected to measurement of water vapor permeability at 40°C and 90% RH using a gas and water vapor permeation analysis system available from GTR Tec Corporation by gas chromatography according to JIS K 7126, Method A (differential pressure method.

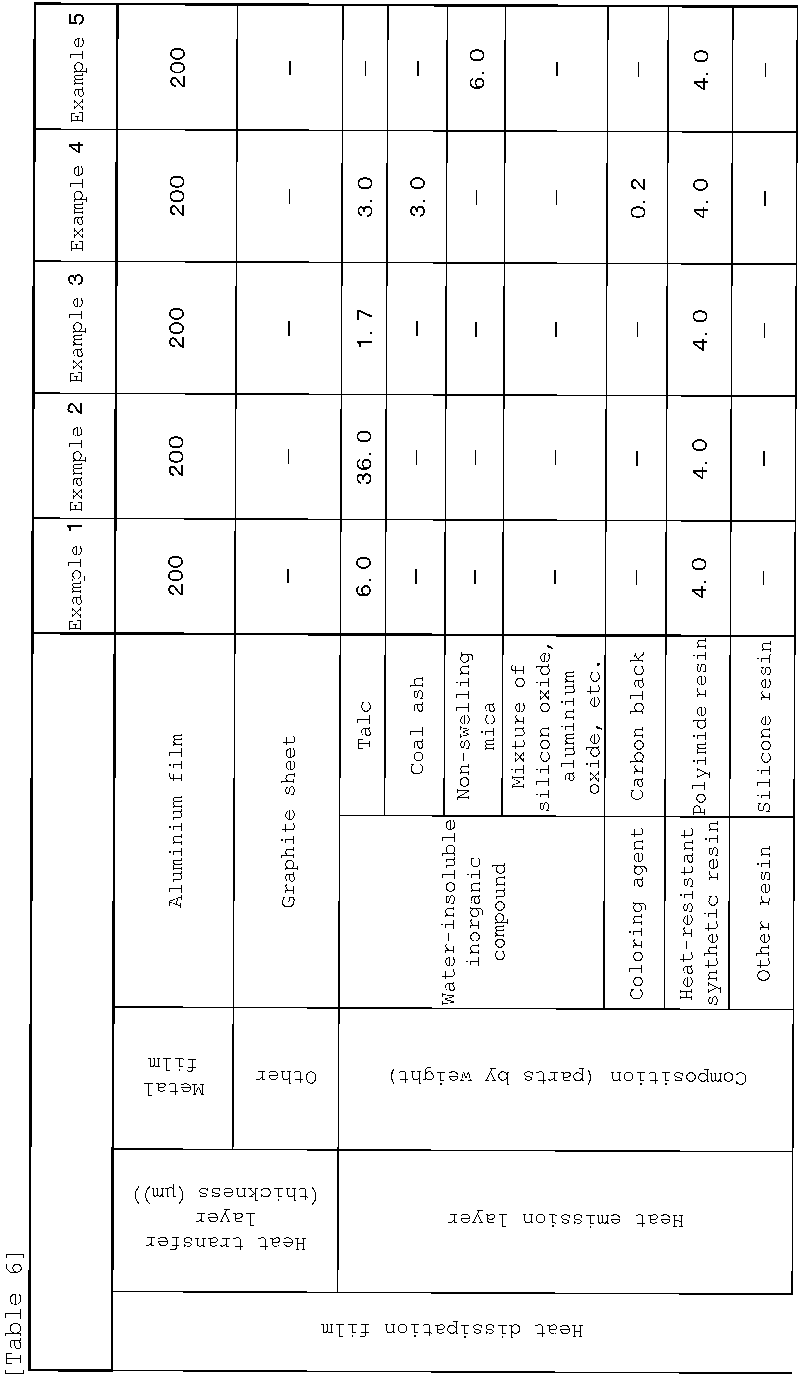

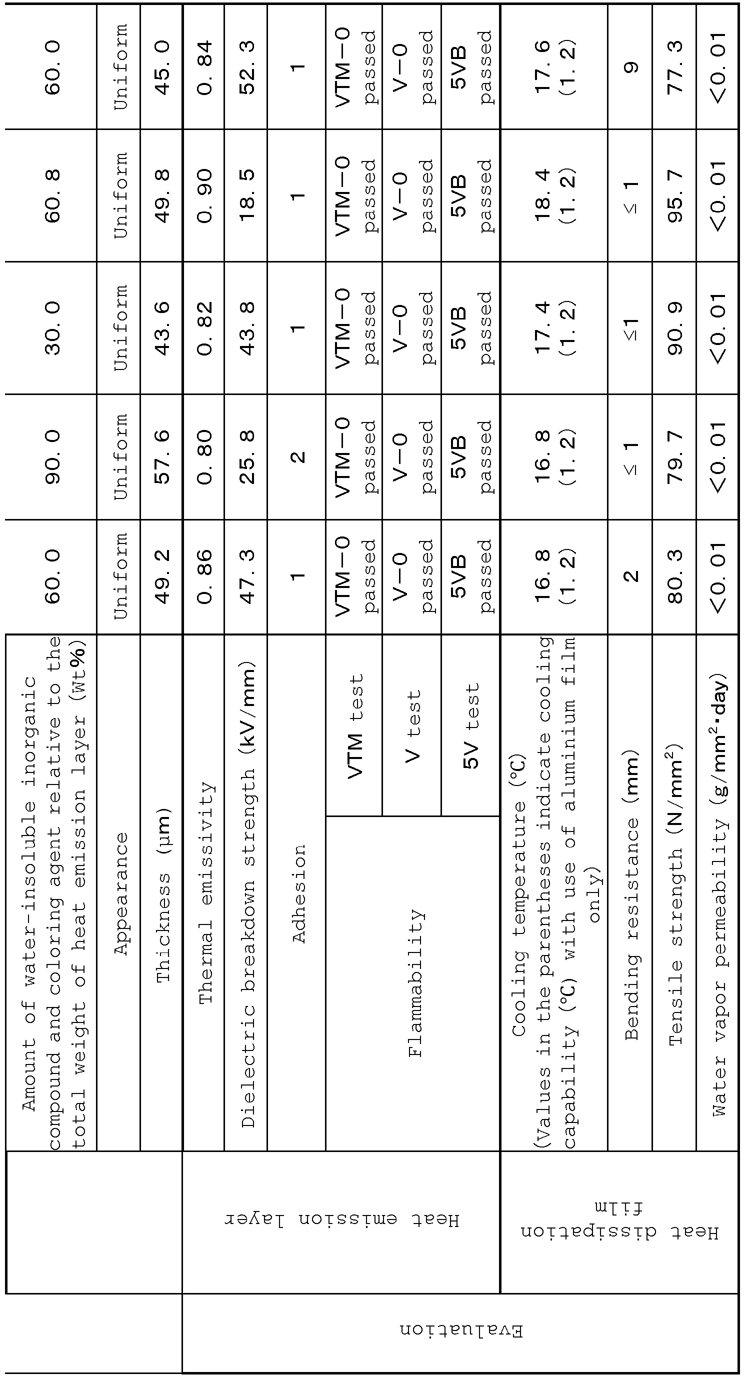

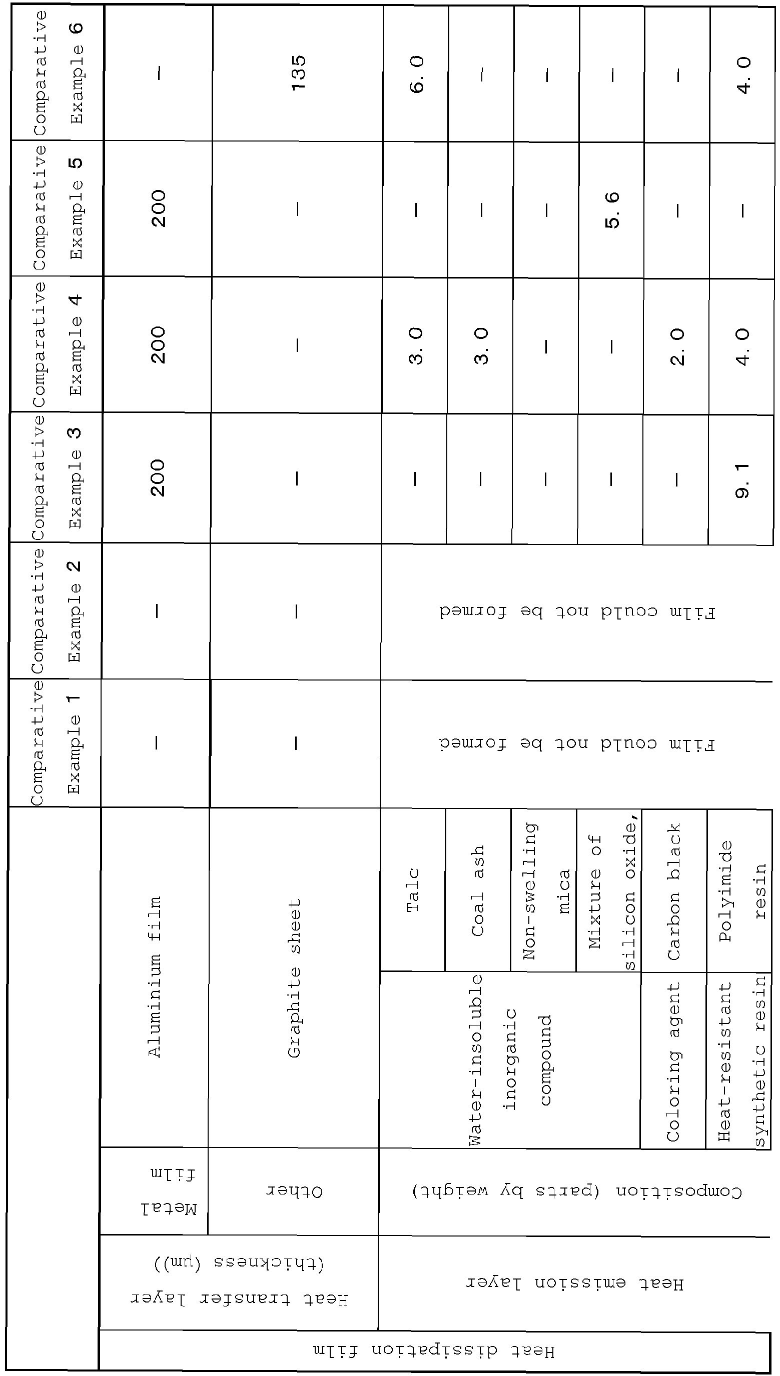

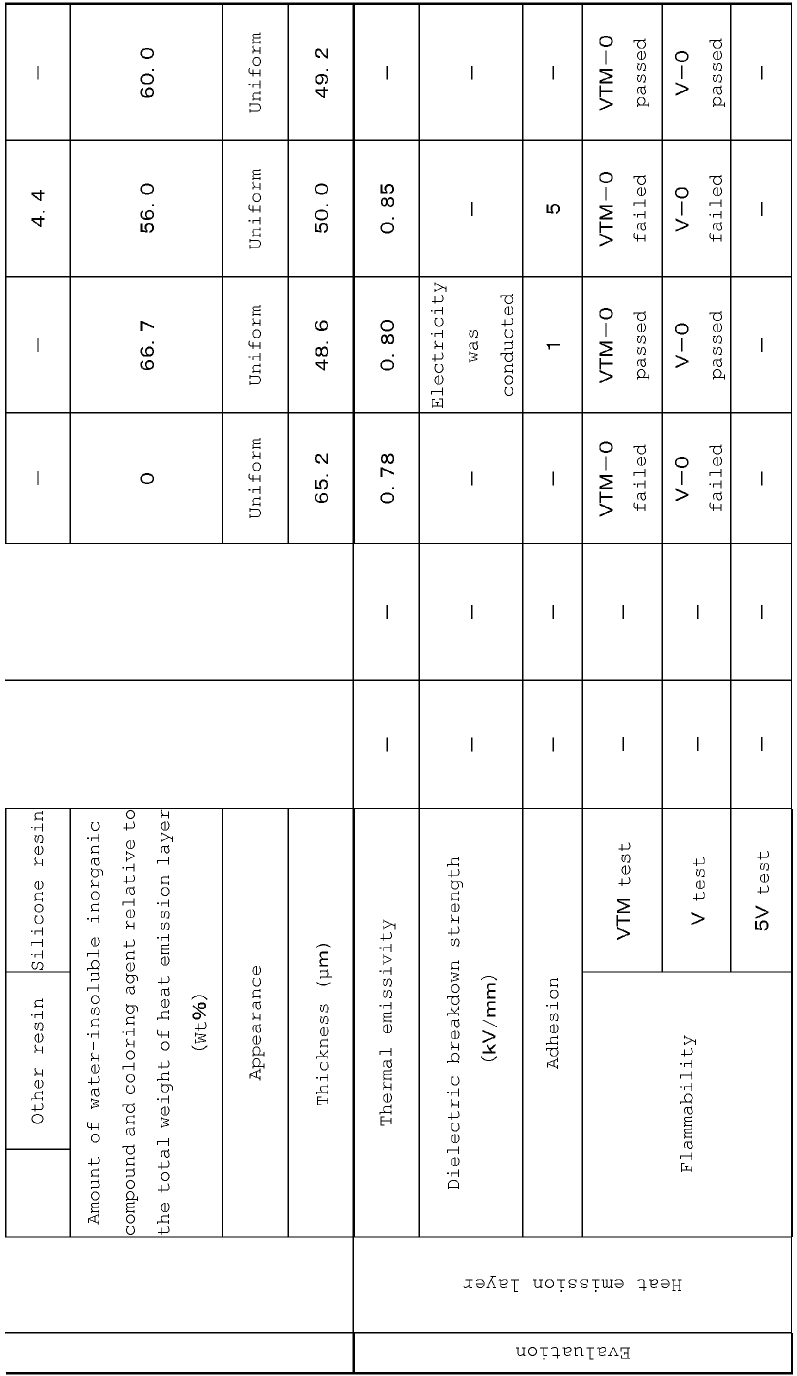

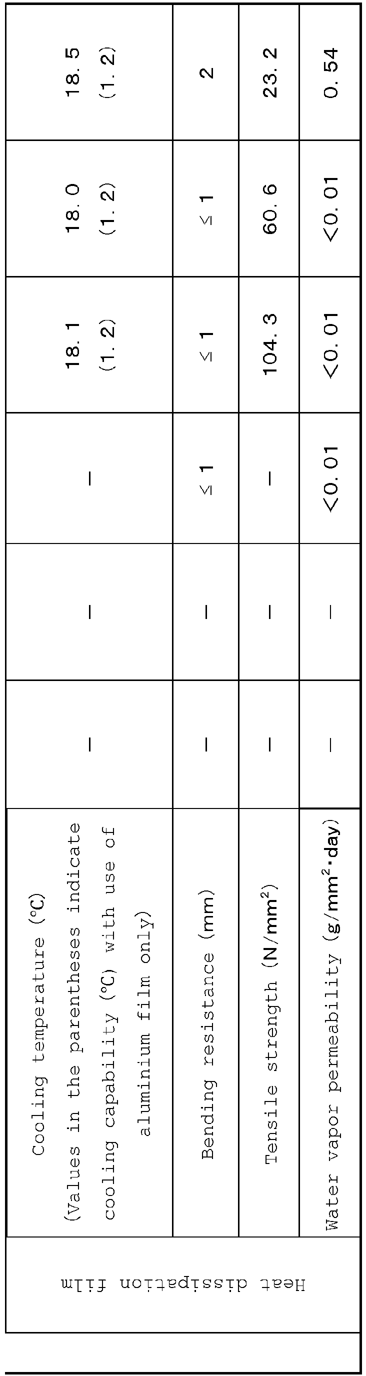

### (Production and performance evaluation of solar cell module)

Two strings each consisting of two 156-mm square, c-Si modules in series were connected to each other by soldering 6-mm-width tabbing wire at 340°C to produce a solar cell. An EVA Sheet ("Sanvic FC" available from Sanvic Inc., 40-cm square) as a sealing material was placed on a glass plate (available from Asahi Glass Co., Ltd., 40-cm square), and the solar cell was placed on the EVA sheet. A transparent Tedlar (registered trademark) having the same area as the solar cell was placed on the cell in such a manner that the cell was sandwiched between two EVA sheets as sealing materials. Lastly, the film produced in Example 4 was placed thereon, a mounting terminal was passed through a slit, and thermocompression bonding was carried out using a vacuum laminator at 135°C for 21 minutes. EVA overflowing from the end portion of the thermocompression bonded-sheet was removed with a hot cutter. A sealing material ("HAMATITE HOTMELT M-155" available from Yokohama Rubber Co., Ltd.) in a heat-molten state was used to fill a groove of an aluminium frame, and such an aluminium frame was fitted to each of the four sides of the laminated sheet. The aluminium frame was fastened with screwed at the four corners, followed by natural drying at room temperature. After drying, a terminal box (Onamba Co., Ltd.) was mounted on the heat dissipation film so as to cover the mounting terminal portion, using a sealing material ("SH780 sealant" available from Dow Corning Toray Co., Ltd.). After natural drying at room temperature, the mounting terminal was soldered to the terminal box at 340°C.
Subsequently, 30 g of a potting agent ("PV-7321" available from Dow Corning Toray Co., Ltd.) (i.e., a mixture of a base agent and a curing agent at a ratio of 10:1) was poured into the terminal box and dried naturally. After standing still about for one week, a cover for the terminal box was mounted. Thus, a finished product of a solar cell module was obtained. Fig. 2 (a) is a photograph of the front side of the solar cell module produced; and Fig. 2 (b) is a photograph of the back side of the solar cell module.

The obtained solar cell module was evaluated for its performance. A fill factor of 0.65 to 0.75 was observed in the evaluation of I-V characteristics. Thus, the output performance of the finished product as a solar cell module was confirmed to be normal.

### INDUSTRIAL APPLICABILITY

The present invention provides a heat dissipation film having high mechanical strength and flexibility, which is obtained by laminating a heat emission layer excellent in heat dissipation by infrared radiation, electrical insulation, and heat resistance on a metal film having excellent heat transfer efficiency. The present invention also provides a dispersion for heat emission layers for use in the production of the heat dissipation film, a method for producing a heat dissipation film using the dispersion for heat emission layers, and a solar cell including the heat dissipation film.

### REFERENCE SIGNS LIST

- 1: Solar cell
- 2: Solar cell element
- 3: Sealing material
- 4: Light-transmissive substrate
- 5: Heat transfer layer
- 6: Heat emission layer

## Claims

1. A heat dissipation film comprising:
a heat transfer layer; and
a flexible heat emission layer laminated on the heat transfer layer,
the heat transfer layer being a metal film,
the heat emission layer containing a water-insoluble inorganic compound and a heat-resistant synthetic resin, the amount of the water-insoluble inorganic compound in the heat emission layer being 30 to 90% by weight relative to the total weight of the heat emission layer,
the heat emission layer having a thermal emissivity of at least 0.8 and a dielectric breakdown strength of at least 10 kV/mm.

2. The heat dissipation film according to claim 1,
wherein the heat emission layer is laminated on one side of the heat transfer layer, and an insulating layer is laminated on the other side of the heat transfer layer,
the insulating layer contains a water-insoluble inorganic compound and a heat-resistant synthetic resin, and the amount of the water-insoluble inorganic compound in the insulating layer is 30 to 90% by weight relative to the total weight of the insulating layer.

3. The heat dissipation film according to claim 1 or 2,
wherein the water-insoluble inorganic compound comprises at least one selected from the group consisting of a silica compound, a silica alumina compound, an aluminium compound, a calcium compound, a nitride, and coal ash.

4. The heat dissipation film according to claim 1, 2, or 3,
wherein the heat dissipation film contains a phyllosilicate mineral as the water-insoluble inorganic compound.

5. The heat dissipation film according to claim 4,
wherein the phyllosilicate mineral is a non-swelling clay mineral.

6. The heat dissipation film according to claim 5,
wherein the non-swelling clay mineral is at least one selected from the group consisting of talc, kaolin, pyrophyllite, and non-swelling mica.

7. The heat dissipation film according to claim 1, 2, 3, 4, 5, or 6,
wherein the heat-resistant synthetic resin is a polyimide resin or a polyamideimide resin.

8. The heat dissipation film according to claim 1, 2, 3, 4, 5, 6, or 7,
wherein the heat emission layer is classified as 0 to 2 for adhesion with the metal film used as the heat transfer layer, as determined by a cross-cut test according to JIS K 5600.

9. The heat dissipation film according to claim 1, 2, 3, 4, 5, 6, 7, or 8,
wherein the heat emission layer is classified as VTM-0 for flammability, as determined by the UL-94 VTM test, and the thickness of the heat emission layer is 100 µm or less when the heat emission layer is classified as VTM-0 for flammability.

10. The heat dissipation film according to claim 1, 2, 3, 4, 5, 6, 7, 8, or 9,
wherein the thickness of the heat emission layer is 20 to 100 µm.

11. The heat dissipation film according to claim 1, 2, 3, 4, 5, 6, 7, 8, 9, or 10,
wherein the metal film as the heat transfer layer is an aluminium film or a copper film.

12. The heat dissipation film according to claim 1, 2, 3, 4, 5, 6, 7, 8, 9, 10, or 11,
wherein the thickness of the heat transfer layer is 10 to 1000 µm.

13. The heat dissipation film according to claim 1, 2, 3, 4, 5, 6, 7, 8, 9, 10, 11, or 12,
wherein the heat dissipation film exhibits a cooling temperature of at least 15°C when the heat dissipation film having the same area as a 2.4-cm square, 0.5- to 1.5-mm-thick ceramic heater is placed on the top of the ceramic heater generating heat with a 3 W power supply.

14. The heat dissipation film according to claim 1, 2, 3, 4, 5, 6, 7, 8, 9, 10, 11, 12, or 13,
wherein the mandrel diameter at which cracking occurs in the heat emission layer of the heat dissipation film is 10 mm or less, as determined by a bend test by a cylindrical mandrel method according to JIS K 5600-5-1 (1999).

15. The heat dissipation film according to claim 1, 2, 3, 4, 5, 6, 7, 8, 9, 10, 11, 12, 13, or 14,
wherein the water vapor permeability of the heat dissipation film at 40°C and 90% RH is lower than 0.01 g/m²·day.

16. A dispersion for heat emission layers for use in the production of the heat dissipation film according to claim 1, 2, 3, 4, 5, 6, 7, 8, 9, 10, 11, 12, 13, 14, or 15, the dispersion for heat emission layers comprising:
a dispersion medium; and
nonvolatile components including a water-insoluble inorganic compound and at least one of a heat-resistant synthetic resin or a heat-resistant synthetic resin precursor;
the amount of the water-insoluble inorganic compound being 30 to 90% by weight relative to the total weight of the nonvolatile components,
the amount of the nonvolatile components being more than 18% by weight and not more than 65% by weight relative to the total weight of the dispersion for heat emission layers.

17. The dispersion for heat emission layers according to claim 16,
wherein the dispersion medium is at least one selected from the group consisting of N-methyl-2-pyrrolidone, N,N-dimethylformamide, N,N-dimethylacetamide, dimethyl sulfoxide, tetrahydrofuran, and sulfolane.

18. A method for producing a heat dissipation film, the method comprising:
step (1-1) of mixing the dispersion medium and the nonvolatile components including a water-insoluble inorganic compound and at least one of a heat-resistant synthetic resin or a heat-resistant synthetic resin precursor to prepare the dispersion for heat emission layers according to claim 16 or 17;
step (1-2) of spreading the prepared dispersion for heat emission layers on a metal film that serves as a heat transfer layer, followed by standing still; and
step (1-3) of removing the dispersion medium from the dispersion for heat emission layers spread on the metal film, forming a film, and obtaining a laminate film.

19. The method for producing a heat dissipation film according to claim 18,
wherein in step (1-2), the thickness of the dispersion spread on the metal film is at least 30 µm.

20. The method for producing a heat dissipation film according to claim 18 or 19,
wherein in step (1-3), the temperature at which the dispersion medium is removed from the dispersion for heat emission layers is 20°C to 150°C.

21. A method for producing a heat dissipation film, the method comprising:
step (2-1) of mixing the dispersion medium and the nonvolatile components including a water-insoluble inorganic compound and at least one of a heat-resistant synthetic resin or a heat-resistant synthetic resin precursor to prepare the dispersion for heat emission layers according to claim 16 or 17;
step (2-2) of spreading the prepared dispersion for heat emission layers on a substrate, followed by standing still;
step (2-3) of removing the dispersion medium from the dispersion for heat emission layers spread on the substrate, forming a film, and separating the film from the substrate to obtain a film as a heat emission layer; and
step (2-4) of adhesively laminating the film as a heat emission layer on the metal film as a heat transfer layer by hot pressing to obtain a laminate film.

22. The method for producing a heat dissipation film according to claim 21,
wherein in step (2-2), the thickness of the dispersion spread on the substrate is at least 30 µm.

23. The method for producing a heat dissipation film according to claim 21 or 22,
wherein in step (2-2), the substrate is made of glass, polyethylene terephthalate, polyimide, polyethylene, or polypropylene.

24. The method for producing a heat dissipation film according to claim 21, 22, or 23,
wherein in step (2-3), the temperature at which the dispersion medium is removed from the dispersion for heat emission layers is 20°C to 150°C.

25. The method for producing a heat dissipation film according to claim 21, 22, 23, or 24,
wherein in step (2-4), the film as a heat emission layer is adhesively laminated on the metal film at a heat-pressing temperature of 50°C to 200°C and a pressure of 10 to 100 kgf/cm².

26. The heat dissipation film according to claim 1, 2, 3, 4, 5, 6, 7, 8, 9, 10, 11, 12, 13, 14, or 15,
wherein the heat dissipation film is used to dissipate heat generated from built-in IC chips or LEDs in electronic devices.

27. A solar cell comprising:
the heat dissipation film according to claim 1, 2, 3, 4, 5, 6, 7, 8, 9, 10, 11, 12, 13, 14, or 15.
